# EUROPÄISCHE PATENTSCHRIFT

(11) **EP 0 691 734 B1**
(45) Veröffentlichungstag und Bekanntmachung des Hinweises auf die Patenterteilung: **22.08.2001**
(21) Anmeldenummer: 95110296.1
(22) Anmeldetag: 30.06.1995
(51) Int. Cl.: H03F 3/45, H03F 3/19

(54) **Verstärkeranordnung für Hochfrequenzsignale**
Amplifier circuit for high frequency signals
Circuit amplificateur pour signaux à haute fréquence

(30) Priorität: 08.07.1994 DE 4424141
(43) Veröffentlichungstag der Anmeldung: 10.01.1996
(73) Patentinhaber: Infineon Technologies AG, 81669 München (DE)
(72) Erfinder: Fenk, Josef, Dipl.-Ing., D-85386 Eching (DE); Herrmann, Helmut, Dipl.-Ing., D-81667 München (DE); Heinen, Stefan, Dr., D-47802 Krefeld (DE)
(74) Vertreter: Zedlitz, Peter, Dipl.-Inf.

(56) Entgegenhaltungen:
- EP-A- 0 176 069
- GB-A- 2 242 089
- US-A- 3 716 727

## Beschreibung

Die Erfindung betrifft eine Verstärkeranordnung für Hochfrequenzsignale nach dem Oberbegriff des Patentanspruchs 1.

Die Erfindung betrifft außerdem eine Multiplexeranordnung mit mindestens einer solchen Verstärkeranordnung.

Bei bisherigen Verstärkeranordnungen, die beispielsweise im Lehrbuch Tietze, Schenk, "Halbleiterschaltungstechnik", 9. Auflage, 1991, Seiten 66 bis 73, beschrieben sind, werden Differenzverstärkerstufen ohne oder mit geringer ohmscher Gegenkopplung der Emitter verwendet. Die Eingangstransistoren werden dabei direkt an die Eingangsignale angekoppelt.

Diese Verstärkerstufen haben den Nachteil, daß die Verstärkung in einer breiten Frequenzbandbreite wirksam ist. Diese reicht im Prinzip vom Gleichsignalanteil bis zur Grenzfrequenz des Verstärkers, die im wesentlichen durch die parasitären Effekte der Bauelemente gegeben ist. Dies bedeutet, daß nicht nur das hochfrequente Nutzsignal, sondern auch tieffrequente Störsignale im Basisband verstärkt werden. Solche Störsignale können etwa durch vorgeschaltete Signalverarbeitungsschaltungen, Logikschaltungen oder Brummschleifen eingekoppelt werden. Wenn den Verstärkerstufen Mischer oder Modulatoren nachgeschaltet sind, werden die Störsignale in Basisband auch dem Nutzsignal im Trägerband überlagert. Dies ist unerwünscht, da der Abstand von Nutzsignal zu Störsignal und die Dynamik verringert werden.

Aus den Stand der Technik GB 2 242 089 A ist ein Vorverstärker mit einstellbarer Verstärkung bekannt. Der Verstärker dient als Mikrophonverstärker zur Verstärkung von Quellen mit niedriger Impedanz. Der Verstärker weist einen Differenzverstärker mit zwei Transistoren auf, die emitterseitig über mehrere Widerstände, wobei einer von diesen einstellbar ist, und eine Kapazität miteinander gekoppelt sind.

Der Erfindung liegt die Aufgabe zugrunde, eine Verstärkeranordnung für Hochfrequenzsignale der eingangs genannten Art derart zu verbessern, daß unerwünschte Störsignalanteile unterdrückt und im wesentlichen nur das hochfrequente Nutzsignal verstärkt wird.

Erfindungsgemäß wird diese Aufgabe durch die kennzeichnenden Merkmale des Patentanspruchs 1 gelöst.

Durch die erfindungsgemäße Verstärkeranordnung werden Signalanteile unterhalb einer über die Dimensionierung der Bauelemente einstellbaren Grenzfrequenz mit 40dB/Dekade gedämpft. Durch die parasitären Effekte der Bauelemente liegt für den Verstärker eine obere Grenzfrequenz vor. Insgesamt wirkt die Verstärkeranordnung als Bandpaß.

Durch Kopplung von zwei Signalpfaden entweder vor der Differenzverstärkerstufe mit den kapazitiv gekoppelten Emit-Hochfrequenzsignalen auf den Ausgang geschaltet werden kann.

Nachfolgend wird die Erfindung anhand der in der Zeichnung dargestellten Figuren näher erläutert. Es zeigen
- Figur 1: eine erste Ausführungsform eines analogen Multiplexers mit zwei erfindungsgemäßen Verstärkerstufen,
- Figur 2: eine zweite Ausführungsform eines analogen Multiplexers und
- Figur 3: eine dritte Ausführungsform eines analogen Multiplexers.

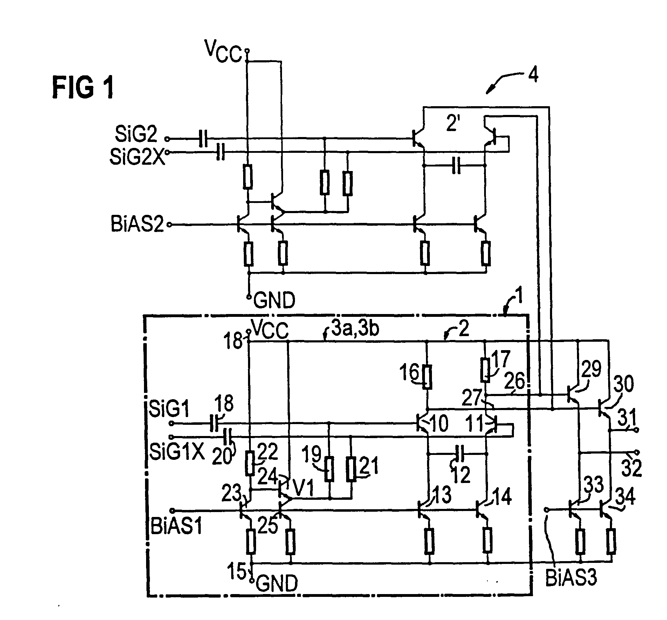

Der in Figur 1 gezeigte analoge Multiplexer enthält zwei erfindungsgemäße Verstärkerstufen für Hochfrequenzsignale, die ausgangsseitig gekoppelt sind. Die Verstärkerstufe 1 wird im Detail beschrieben. Diese enthält einen Differenzverstärker 2 mit zwei emittergekoppelten Transistoren 10, 11. Die Emitter der Transistoren sind kapazitiv über einen Kondensator 12 gekoppelt. Jeder Emitter wird über eine Stromquelle 13, 14 mit einem Anschluß 15 für ein Massepotential GND verbunden. Die Kollektoren der Transistoren 10, 11 sind über je einen Arbeitswiderstand 16, 17 mit einem Anschluß 18 für ein positives Versorgungspotential VCC verbunden. Die Eingangssignale des Differenzverstärkers 2, die an den Basisanschlüssen der Transistoren 10, 11 eingespeist werden, werden über je ein Filter mit Hochpaßcharakteristik 3a, 3b eingespeist. Das Filter 3a, das mit dem Basisanschluß des Transistors 10 verbunden ist, enthält einen Kondensator 18, über den ein Eingangssignal SIG1 an die Basis des Transistors 10 gekoppelt wird, und einen Widerstand 19, über den der mit der Basis des Transistors 10 verbundene Anschluß des Kondensators 18 mit einem Referenzpotential V1 verbunden ist. In entsprechender Weise wird das zum Signal SIG1 komplementäre Signal SIG1X über das Hochpaßfilter 3b, das einen Längskondensator 20 und Querwiderstand 21 enthält, an die Basis des Transistors 11 gekoppelt. Zur Erzeugung des Referenzpotentials V1 ist ein zwischen den Potentialen VCC und GND geschalteter Strompfad aus einem Widerstand 22 mit masseseitiger Stromquelle 23 vorgesehen. An den Widerstand 22 ist ein Emitterfolgertransistor 24 angeschlossen, der emitterseitig über eine Stromquelle 25 mit dem Masseanschluß 15 verbunden ist. Am Emitter des Transistors 24 ist das Referenzpotential V1 abgreifbar. Die Stromquellen 13, 14 und 23, 25 sind vorzugsweise an ein gemeinsames Steuerpotential BIAS1 angeschlossen. Das Referenzpotential BIAS1 kann beispielsweise über einen Strom-Spannungs-Wandler von einem Referenzstrom abgeleitet werden.

Der erfindungsgemäße Verstärker 1 arbeitet wie nachfolgend beschrieben. Die hochfrequenten Nutzsignale SIG1, SIG1X werden mittels der Hochpaßfilter 3a, 3b gefiltert, so daß niedrigfrequente Störsignale gedämpft werden. Die Grenzfrequenz der Hochpässe kann durch entsprechende Dimensionierung der Widerstände 19, 21 eingestellt werden. Die Kondensatoren 18, 20 haben relativ kleine Kapazitätswerte, so daß sie auch in integrierter Form realisiert werden können. Die mittels der Filter 3a, 3b hochpaßgefilterten Signale SIG1, SIG1X steuern den Verstärker 2 differentiell im Gegentakt an. Die kapazitive Emitterkopplung 12 sorgt dafür, daß die Emitter der Transistoren 10, 11 bei hochfrequenten Signalanteilen gut gekoppelt sind. Bei niedrigfrequenten Signalanteilen sind die Emitter der Transistoren 10, 11 nahezu ungekoppelt. Demzufolge weist der Verstärker 2 für hochfrequente Signalanteile eine hohe Verstärkung, für niedrigfrequente Signalanteile eine geringe Verstärkung auf. Der Differenzverstärker 2 mit den kapazitiv gekoppelten Emittern wirkt somit als weiterer Hochpaß, dessen Grenzfrequenz über die geeignete Dimensionierung der Arbeitswiderstände 16, 17 im Zusammenhang mit dem Kondensator 12 eingestellt wird. An den mit den Arbeitswiderständen verbundenen Ausgängen 26, 27 ist das verstärkte und zweifach hochpaßgefilterte differentielle Signal abgreifbar. An diesen Ausgängen nachgeschalteten Emitterfolgertransistoren 29, 30 mit je einer emitterseitigen Stromquelle 33, 34 liegt das Nutzsignal niederohmig vor.

In den Eingangs-Ausgangs-Signalpfad der Signale SIG1, SIG1X sind also je zwei Hochpaßfilter 3a bzw. 3b, 2 geschaltet, so daß sich für tiefe Frequenzen eine Dämpfung von 40dB/Dekade ergibt. Durch die Emitterfolgertransistoren 29, 30 und die parasitären Elemente insbesondere des Differenzverstärkers 2 ergibt sich eine praktische Verstärkung bis zu einer oberen Grenzfrequenz. Die Schaltung hat somit insgesamt Bandpaßcharakter. Da die verwendeten Kondensatoren 12, 18, 20 relativ geringe Kapazitätswerte aufweisen, können diese Kondensatoren integriert werden. Die gesamte Schaltung kann deshalb ohne Verwendung von diskreten Bauelementen in einer einzigen integrierten Schaltung realisiert werden.

In vorteilhafter Anwendung der Verstärkerstufe kann ein analoger Multiplexer wie in Figur 1 gezeigt, aus zwei Verstärkerstufen 1, 4 realisiert werden. Es kann eines der Gegentakteingangssignalpaare SIG1, SIG1X bzw. SIG2, SIG2X auf die Ausgänge 31, 32 des Multiplexers geschaltet werden. Zur Umschaltung wird nur eine der Steuerspannungen BIAS1 bzw. BIAS2 für die Stromquellen der jeweiligen Signalpfade aktiv geschaltet. Die Kollektoren der Transistoren der jeweiligen Differenzverstärker sind gekoppelt, so daß die Arbeitswiderstände 16, 17 beiden Verstärkerstufen gemeinsam sind. Die emitterseitigen Stromquellen der Emitterfolgertransistoren 29, 30 werden von einem weiteren Steuerpotential BIAS3 angesteuert.

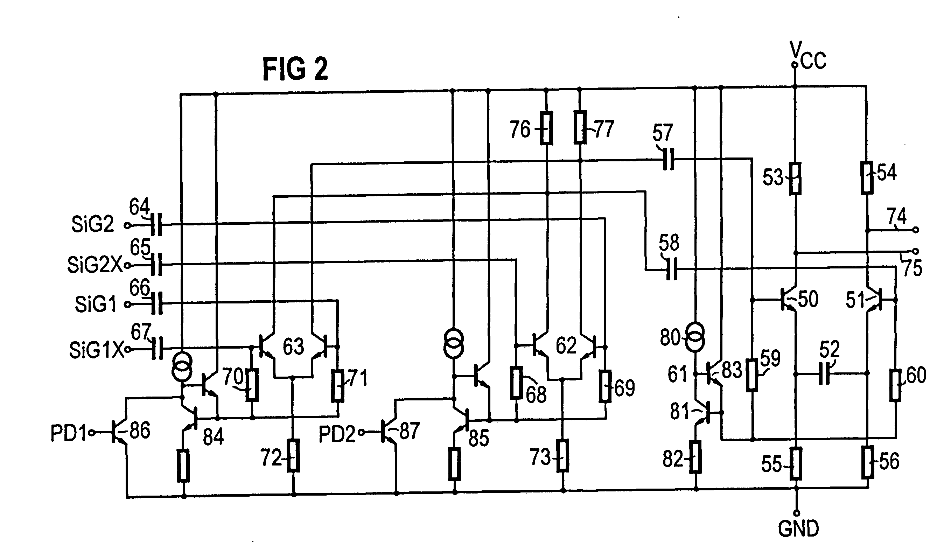

Eine andere Realisierung für einen Multiplexer enthaltend eine erfindungsgemäße Verstärkerstufe ist in Figur 2 gezeigt. Eines der differentiellen Eingangssignale SIG1, SIG1X bzw. SIG2; SIG2X wird in Abhängigkeit von den Steuersignalen PD1, PD2 auf die Gegentaktausgänge 74, 75 geschaltet. Hierzu werden die Signale SIG1, SIG1X über je ein Hochpaßfilter 66, 71 bzw. 67, 70 einem ersten Differenzverstärker 63 zugeführt. Dieser Differenzverstärker weist Transistoren mit miteinander verbundenen Emittern auf. Die Emitter sind anstelle einer Stromquelle mit einem eingeprägten Strom über einen Widerstand 72 nach Masse GND verbunden. Die Signale SIG2X werden über je ein Hochpaßfilter 64, 69 bzw. 65, 68 einer zweiten Differenzverstärkerstufe 62 zugeführt, deren gekoppelte Emitter über einen Widerstand 73 nach Masse verbunden sind. Ausgangsseitig sind die Kollektorzweige der Transistoren der Differenzverstärker 63, 62 an einem gemeinsamen Arbeitswiderstandspaar 76, 77 gekoppelt. Die an den Widerständen 76, 77 abgreifbaren Gegentaktsignale werden über je ein weiteres Hochpaßfilter 58, 60 bzw. 57, 59 dem ausgangsseitgen Differenzverstärker 50...56 mit kapazitiv gekoppelten Emittern zugeführt. An dessen Arbeitswiderständen 53, 54 sind die Ausgangssignalanschlüsse 75 bzw. 74 angeschlossen. Auch die Emitter des letztgenannten Differenzverstärkers werden jeweils über Widerstände 55, 56 nach Masse verbunden. Dadurch daß die Emitter anstelle einer Stromquelle mit eingeprägtem Strom über Widerstände 55, 56, 72, 73 nach Masse verbunden sind, kann die Versorgungsspannung der Gesamtschaltung niedriger gewählt werden.

Zur Arbeitspunkteinstellung der Hochpaßfilter ist jeweils eine Schaltung vorgesehen, die mit 61 bezeichnet ist. Diese enthält eine mit dem Versorgungspotential VCC verbundene Stromquelle 80, die in Reihe mit der Kollektor-Emitter-Strecke eines Transistors 81 mit emitterseitigem Widerstand 82 liegt. Zwischen Kollektor und Basis des Transistors 81 ist die Basis-Emitter-Strecke eines weiteren Transistors 83 geschaltet. Am Emitter des Transistors 83 ist die Referenzspannung zur Einstellung des Arbeitspunkts der Hochpaßfilter 57, 59 und 58, 60 abgreifbar. Die Referenzspannungsquellen 84, 85 für die übrigen Hochpaßfilter sind entsprechend aufgebaut. Diese letztgenannten Referenzspannungsquellen sind über je einen Transistor 86 bzw. 87, an denen die Signale PD1 bzw. PD2 anliegen, abschaltbar. Damit kann eines der Gegentaktsignalpaare SIG1, SIG1X oder SIG2, SIG2X ausgewählt werden.

Bei dem in Figur 2 gezeigten Multiplexer sind drei Hochpaßstufen in einen Eingangs-Ausgangs-Signalpfad geschaltet, nämlich die Hochpaßfilter 67, 70; 66, 71 bzw. 65, 68; 64, 69 sowie die Hochpaßfilter 58, 60 und 57, 59 sowie der Differenzverstärker 50...56 mit den über die Kapazität 52 gekoppelten Emittern. Der Multiplexer der Figur 2 ist also besonders für niedrige Versorgungsspannungen vorteilhaft verwendbar, wobei eine noch höhere Dämpfung von 60dB/Dekade für die Signalanteile im Basisband erreicht werden.

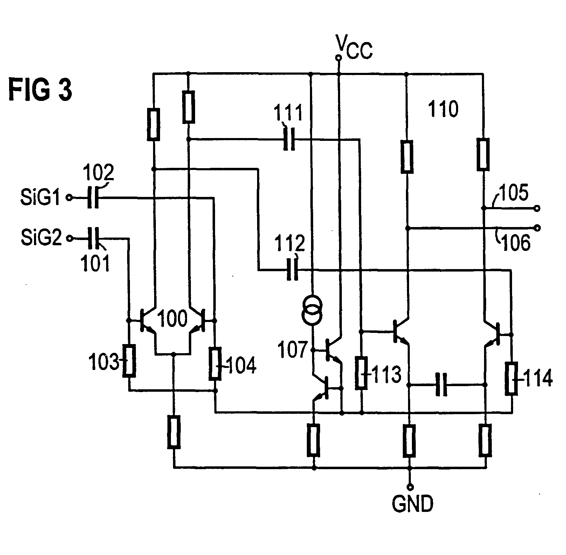

Eine weitere Ausführungsform eines analogen Multiplexers unter Verwendung einer erfindungsgemäßen Verstärkeranordnung ist in Figur 3 gezeigt. Diese unterscheidet sich von der Realisierung nach Figur 2 dadurch, daß anstelle von Gegentaktsignalen unsymetrische Signale SIG1, SIG2 eingespeist werden. Hierzu ist vor der ausgangsseitigen Differenzverstärkerstufe 110 mit den kapazitiv gekoppelten Emittern und den vorgeschalteten Hochpässen 111, 113; 112, 114 ein einziger Differenzverstärker 100 vorgesehen. Die Signale SIG1, SIG2 werden über jeweilige Hochpaßeinrichtungen 102, 104 bzw. 101, 103 eingekoppelt. Zur Arbeitspunkteinstellung aller RC-Hochpässe ist ein einziger Referenzspannungsgenerator 107 vorgesehen. An den Ausgängen 105, 106 des Multiplexers kann eines der gefilterten Signale SIG1, SIG2 wieder als Gegentaktsignale abgegriffen werden. Es ist notwendig, daß jeweils nur eines der Signale SIG1 oder SIG2 aktiv ist. Das andere muß dabei abgeschaltet sein. Dies kann durch entsprechende Schaltungsmaßnahmen am Schaltungseingang erreicht werden. Der entsprechende Transistor des Differenzverstärkers 100 wird dann von einem konstanten, vom Referenzspannungsgenerator 107 abgeleiteten Signal gesteuert. Diese Schaltung eignet sich als besonders platzsparende Multiplexervariante für Eingangssignale mit höherem Störabstand.

## Patentansprüche

1. Verstärkeranordnung für Hochfrequenzsignale, bei der ein Differenzverstärker (2) vorgesehen ist, mit zwei an den Emittern über eine Kapazität (12) gekoppelten Transistoren (10, 11), an deren Basisanschlüssen je ein zu verstärkendes Signal (SIG1, SIG1X) über je eine Anordnung mit Hochpaßcharakter (18, 19; 20, 21) anlegbar sind, wobei die Anordnungen mit Hochpaßcharakter (18, 19; 20, 21) jeweils umfassen:
- ein kapazitives Element (18; 20), dessen erster Anschluß ein Anschluß für das jeweilige zu verstärkende Signal (SIG1, SIG1X) ist und dessen zweiter Anschluß mit der Basis eines der Transistoren (10, 11) verbunden ist, und
- ein ohmsches Element (19; 21), dessen erster Anschluß mit dem zweiten Anschluß des kapazitiven Elements (18; 20) verbunden ist und dessen zweiter Anschluß ein Anschluß für ein Referenzpotential (V1) ist;
bei der die Emitter der Transistoren (10, 11) des Differenzverstärkers (2) jeweils über eine Stromquelle (13, 14) mit einem ersten Anschluß (15) verbunden sind, der mit einem ersten Versorgungspotential (GND) verbunden ist,
bei der eine erste und eine zweite weitere mit dem ersten Anschluß (15) verbundene Stromquelle (23, 25) vorgesehen sind, von denen die erste über einen Widerstand (22) mit einem zweiten Anschluß (5) verbunden ist, der mit einem zweiten Versorgungspotential (VCC) verbunden ist und von denen die zweite über die Emitter-Kollektor-Strecke eines weiteren Transistors (24) mit dem zweiten Anschluß (5) verbunden ist,
bei der die Basis des weiteren Transistors (24) mit dem Widerstand (22) und der ersten Stromquelle (23) verbunden ist, und
bei der der Emitter des weiteren Transistors (24) ein Abgriff für das Referenzpotential (V1) ist.

2. Verstärkeranordnung nach Anspruch 1,
bei der die Stromquellen (13, 14) und weiteren Stromquellen (23, 25) von einem gemeinsamen Steuersignal (BIAS1) steuerbar sind.

3. Verstärkeranordnung für Hochfrequenzsignale, bei der ein Differenzverstärker (50...56) vorgesehen ist, mit zwei an den Emittern über eine Kapazität (52) gekoppelten Transistoren (50,51), an deren Basisanschlüssen je ein zu verstärkendes Signal (SIG1, SIG1X) über je eine Anordnung mit Hochpaßcharakter (57, 59; 58,60) anlegbar sind, wobei die Anordnungen mit Hochpaßcharakter (57, 59; 58,60) jeweils umfassen:
- ein kapazitives Element (57; 58), dessen erster Anschluß ein Anschluß für das zu verstärkende Signal (SIG1, SIG1X) ist und dessen zweiter Anschluß mit der Basis eines der Transistoren (50, 51) verbunden ist, und
- ein ohmsches Element (59; 60), dessen erster Anschluß mit dem zweiten Anschluß des kapazitiven Elements (57; 58) verbunden ist und dessen zweiter Anschluß ein Anschluß für ein Referenzpotential ist;
bei der die Emitter der Transistoren (50, 51) des Differenzverstärkers (50...56) jeweils über einen Widerstand (55, 56) mit einem ersten Anschluß verbunden sind, der mit einem ersten Versorgungspotential (GND) verbunden ist,
bei der ein weiterer erster Transistor (81) vorgesehen ist, dessen Emitter über einen Widerstand (82) mit dem ersten Anschluß verbunden ist und in dessen Kollektor ein Strom (80) eingeprägt wird,
bei der die Basis des weiteren ersten Transistors (81) ein Abgriff für das Referenzpotential ist,
bei der der Kollektor des weiteren ersten Transistors (81) mit der Basis eines weiteren zweiten Transistors (83) und die Basis des weiteren ersten Transistors (81) mit dem Emitter des weiteren zweiten Transistors (83) verbunden ist, sowie weiterhin der Kollektor des weiteren zweiten Transistors (83) mit einem zweiten Anschluß verbunden ist, der mit einem zweiten Versorgungspotential (VCC) verbunden ist.

4. Verstärkeranordnung nach einem der Ansprüche 1 bis 3, bei der die zu verstärkenden Signale differentiell im Gegentakt auf dem Verstärker gegeben werden.

5. Verstärkeranordnung nach einem der Ansprüche 1 bis 4, bei der ein weiterer Differenzverstärker (62; 63) vorgesehen ist, dessen Ausgänge mit je einer der Anordnungen (58, 60; 57, 59) mit Hochpaßcharakter verbunden sind, und bei der dem weiteren Differenzverstärker (62; 63) die zu verstärkenden Signale eingangsseitig über weitere Einrichtungen mit Hochpaßcharakter (64...71) zuführbar sind.

6. Verstärkeranordnung nach einem der Ansprüche 1 bis 5, bei der Ausgängen (26, 27) des Differenzverstärkers (2) je ein Emitterfolgertransistor (29, 30) nachgeschaltet ist.

7. Multiplexeranordnung enthaltend zwei Verstärkeranordnungen nach einem der Ansprüche 1 bis 4, bei der die Kollektoren der Transistoren der Differenzverstärker paarweise gekoppelt und an je einen Widerstand (16, 17) und einen Anschluß (26, 27) für ein Ausgangssignal angeschlossen sind.

8. Multiplexeranordnung enthaltend eine Verstärkeranordnung nach Anspruch 5,
bei der ein zweiter weiterer Differenzverstärker (63; 62) vorgesehen ist, dessen Differenzverstärkerzweige mit den Differenzverstärkerzweigen des weiteren Differenzverstärkers (62; 63) paarweise gekoppelt sind und daß der zweite weitere Differenzverstärker (63; 62) eingangsseitig über je eine zweite weitere Anordnung mit Hochpaßcharakteristik (64...71) von weiteren zu verstärkenden Signalen angesteuert wird.

## Claims

1. Amplifier arrangement for radio-frequency signals,
in which a differential amplifier (2) is provided which has two transistors (10,11) which are coupled to the emitters via a capacitance (12) and to whose base connections a respective signal (SIG1,SIG1X) which is to be amplified can be applied via a respective arrangement with a high-pass filter character (18,19; 20,21), the arrangements with a high-pass filter character (18,19;20,21) each comprising:
- a capacitive element (18;20) whose first connection is a connection for the respective signal (SIG1,SIG1X) to be amplified and whose second connection is connected to the base of one of the transistors (10,11), and
- a resistive element (19;21) whose first connection is connected to the second connection of the capacitive element (18;20) and whose second connection is a connection for a reference potential (V1);
in which the emitters of the transistors (10,11) in the differential amplifier (2) are connected via a respective current source (13,14) to a first connection (15), which is connected to a first supply potential (GND),
in which a first and a second further current source (23,25), connected to the first connection (15), are provided, the first of which is connected via a resistor (22) to a second connection (5), which is connected to a second supply potential (VCC), and the second of which is connected to the second connection (5) via the emitter/collector path of a further transistor (24),
in which the base of the further transistor (24) is connected to the resistor (22) and to the first current source (23), and
in which the emitter of the further transistor (24) is a tap for the reference potential (V1).

2. Amplifier arrangement according to Claim 1,
in which the current sources (13,14) and further current sources (23,25) can be controlled by a common control signal (BIAS1).

3. Amplifier arrangement for radio-frequency signals,
in which a differential amplifier (50...56) is provided which has two transistors (50,51) which are coupled to the emitters via a capacitance (52) and to whose base connections a respective signal (SIG1,SIG1X) which is to be amplified can be applied via a respective arrangement with a high-pass filter character (57,59; 58,60), the arrangements with a high-pass filter character (57,59;58,60) each comprising:
- a capacitive element (57;58) whose first connection is a connection for the signal (SIG1, SIG1X) to be amplified and whose second connection is connected to the base of one of the transistors (50,51), and
- a resistive element (59;60) whose first connection is connected to the second connection of the capacitive element (57;58) and whose second connection is a connection for a reference potential;
in which the emitters of the transistors (50,51) in the differential amplifier (50...56) are connected via a respective resistor (55,56) to a first connection, which is connected to a first supply potential (GND), in which a further first transistor (81) is provided, whose emitter is connected to the first connection via a resistor (82) and whose collector has a current (80) impressed into it,
in which the base of the further first transistor (81) is a tap for the reference potential,
in which the collector of the further first transistor (81) is connected to the base of a further second transistor (83), and the base of the further first transistor (81) is connected to the emitter of the further second transistor (83), and also the collector of the further second transistor (83) is connected to a second connection, which is connected to a second supply potential (VCC).

4. Amplifier arrangement according to one of Claims 1 to 3,
in which the signals to be amplified are supplied to the amplifier differentially in a push-pull manner.

5. Amplifier arrangement according to one of Claims 1 to 4,
in which a further differential amplifier (62;63) is provided, whose outputs are connected to a respective one of the arrangements (58,60;57,59) with a high-pass filter character, and
in which the input of the further differential amplifier (62;63) can be supplied with the signals to be amplified via further devices with a high-pass filter character (64...71).

6. Amplifier arrangement according to one of Claims 1 to 5,
in which outputs (26,27) of the differential amplifier (2) have a respective emitter-follower transistor (29,30) connected downstream of them.

7. Multiplexer arrangement containing two amplifier arrangements according to one of Claims 1 to 4,
in which the collectors of the transistors in the differential amplifiers are coupled in pairs and are connected to a respective resistor (16,17) and to a connection (26,27) for an output signal.

8. Multiplexer arrangement containing an amplifier arrangement according to Claim 5,
in which a second further differential amplifier (63;62) is provided, whose differential amplifier paths are coupled in pairs to the differential amplifier paths of the further differential amplifier (62;63), and in that the second further differential amplifier (63;62) is driven at the input via a respective second further arrangement with a high-pass filter characteristic (64...71) by further signals which are to be amplified.

## Revendications

1. Agencement d'amplification pour signaux à haute fréquence, dans lequel est prévu un amplificateur différentiel (2) présentant deux transistors (10, 11) couplés par leurs émetteurs par l'intermédiaire d'une capacité (12), aux bornes de base desquels un signal à amplifier (SIG1, SIG1X) peut être appliqué chaque fois par l'intermédiaire d'un agencement à caractère passe-haut (18, 19; 20, 21), les agencements à caractère passe-haut (18, 19; 20, 21) comprenant chacun :
- un élément capacitif (18; 20), dont la première borne est une borne pour le signal respectif à amplifier (SIG1, SIG1X) et dont la deuxième borne est reliée à la base de l'un des transistors (10, 11), et
- un élément ohmique (19; 21) dont la première borne est reliée à la deuxième borne de l'élément capacitif (18; 20) et dont la deuxième borne est la borne de raccordement d'un potentiel de référence (V1);
dans lequel les émetteurs des transistors (10, 11) de l'amplificateur différentiel (2) sont chacun reliés, par l'intermédiaire d'une source de courant (13, 14) respective, à une première borne (15) qui est reliée à un premier potentiel d'alimentation (GND);
dans lequel sont prévues une première et une deuxième autre source de courant (23, 25) reliées à la première borne (15), dont la première est reliée par l'intermédiaire d'une résistance (22) à une deuxième borne de raccordement (5) qui est reliée à un deuxième potentiel d'alimentation (VCC) et dont la deuxième est reliée par l'intermédiaire du parcours émetteur-collecteur d'un autre transistor (24) à la deuxième borne de raccordement (5),
dans lequel la base de l'autre transistor (24) est reliée à la résistance (22) et à la première source de courant (23), et
dans lequel l'émetteur du deuxième transistor (24) est le point de reprise du potentiel de référence (V1).

2. Agencement d'amplification selon la revendication 1, dans lequel les sources de courant (13, 14) et les autres sources de courant (23, 25) peuvent être commandées par un signal de commande commun (BIAS1).

3. Agencement d'amplification de signaux à haute fréquence dans lequel un amplificateur différentiel (50 ... 56) est prévu, avec deux transistors (50, 51) couplés aux émetteurs par l'intermédiaire d'une capacité (52) et aux bornes de base desquelles un signal à amplifier (SIG1, SIG1X) respectif peut être appliqué par l'intermédiaire d'un agencement à caractère passe-haut (57, 59; 58, 60), les agencements à caractère passe-haut (57, 59; 58, 60) comprenant chacun :
- un élément capacitif (57; 58), dont la première borne forme une borne pour le signal à amplifier (SIG1, SIG1X) et dont la deuxième borne est reliée à la base de l'un des transistors (50, 51), et
- un élément ohmique (59; 60) dont la première borne est reliée à la deuxième borne de l'élément capacitif (57; 58) et dont la deuxième borne forme une borne de raccordement pour un potentiel de référence;
dans lequel les émetteurs des transistors (50, 51) de l'amplificateur différentiel (50 ... 56) sont chacun reliés par une résistance (55, 56) à une première borne qui est reliée à un premier potentiel d'alimentation (GND),
dans lequel est prévu un autre premier transistor (81) dont l'émetteur est relié par l'intermédiaire d'une résistance (82) à la première borne de raccordement et dans le collecteur duquel un courant (80) est injecté,
dans lequel la base de l'autre premier transistor (81) forme un point de reprise du potentiel de référence,
dans lequel le collecteur de l'autre premier transistor (81) est relié à la base d'un autre deuxième transistor (83) et la base de l'autre premier transistor (81) est reliée à l'émetteur de l'autre deuxième transistor (83), et en outre le collecteur de l'autre deuxième transistor (83) est relié à une deuxième borne de raccordement qui est reliée à un deuxième potentiel d'alimentation (VCC).

4. Agencement d'amplification selon l'une des revendications 1 à 3, dans lequel les signaux à amplifier sont appliqués de manière différentielle, à cadence opposée, sur l'amplificateur.

5. Agencement d'amplification selon l'une des revendications 1 à 4, dans lequel est prévu un autre amplificateur différentiel (62; 63) dont les sorties sont reliées chacune à l'un des agencements (58, 60; 57, 59) à caractère passe-haut, et dans lequel les signaux à amplifier peuvent être appliqués sur l'autre amplificateur différentiel (62; 63) du côté de l'entrée, par d'autres dispositifs à caractère passe-haut (64 ... 71).

6. Agencement d'amplification selon l'une des revendications 1 à 5, dans lequel un transistor suiveur d'émetteur (29, 30) respectif est branché en aval de chacune des sorties (26, 27) de l'amplificateur différentiel (2).

7. Agencement de multiplexage contenant deux agencements d'amplification selon l'une des revendications 1 à 4, dans lequel les collecteurs des transistors des amplificateurs différentiels sont couplés par paire et sont raccordés chaque fois à une résistance (16, 17) et à une borne de raccordement (26, 27) pour un signal de sortie.

8. Agencement de multiplexage contenant un agencement d'amplification selon la revendication 5, dans lequel un autre deuxième amplificateur différentiel (63; 62) est prévu, dont les branches d'amplificateur différentiel sont couplées par paire aux branches d'applicateur différentiel de l'autre amplificateur différentiel (62; 63), et le deuxième autre amplificateur différentiel (63; 62) est commandé du côté de son entrée par d'autres signaux à amplifier, chaque fois par l'intermédiaire d'un deuxième autre agencement à caractéristique passe-haut (64 ... 71).
